# EUROPEAN PATENT APPLICATION

(11) **EP 1 445 853 A2**
(43) Date of publication of application: **11.08.2004**
(21) Application number: 03257230.7
(22) Date of filing: 17.11.2003
(51) Int. Cl.: H02M 7/00

(54) **Converter module**

(30) Priority: 15.11.2002 GB 0226714
(71) Applicant: Bombardier Transportation GmbH, 13627 Berlin (DE)
(72) Inventor: Still, Michael, 64683 Einhausen (DE); Still, Ludwig, 64683 Einhausen (DE)
(74) Representative: Akers, Noel James

(57) **Abstract**

A converter module comprises a heat sink (31) and a semiconductor phase mounted on the heat sink (31). The semiconductor phase comprises a pair of semiconductor modules (32) having an AC busbar (AC) connected to the emitter (2) of one semiconductor module and the collector (1) of the other semiconductor module (32) and a pair of DC busbars connected respectively to the remaining collector (1) and emitter terminals of the pair of semiconductor modules. The AC busbar (AC) is connected to form a substantially symmetrical low inductance system. By providing symmetrical connection to the semiconductor modules it is assured that all components are loaded equally.

The converter may comprise 12 IGBT modules (32) configured in different arrangements according to the output required. To improve reliability and operation the modules are arranged in an enclosed housing with the gate drives shielded from the semiconductor elements by the heat sink.

## Description

The present invention relates to a converter module and in particular to structural configurations and designs of such a converter for a DC intermediate circuit. In particular, the present invention relates to a converter module in which by simply changing the configuration of the semiconductor connections of a standard format unit allows for alternative capacity by parallel switching of semiconductor modules. Such converter modules are especially suitable, for example, for use in providing traction power to rail vehicles using insulated gate bipolar transistors (IGBTs).

Prior art units are known containing configurations of 2 to 8 semiconductor modules on a single unit. Such configurations are known from Marc Debruyne, High power IGBT-Traction drives, World Congress on Railway Research, Cologne 2001-11-28, and Thomas Lüttin, Dr. Ingo Herbst, Urs Meyer, Eisenbahn-Revue International of December 1999. The simplest basic configuration commonly used is a 2-point circuit, consisting of the series connection of 2 controllable semiconductors with an anti-parallel diode, hereafter referred to as an auxiliary unit. Using the controllable semiconductors the positive/negative potentials of the DC intermediate circuit are alternately switched to the middle AC-alternating voltage output /alternating voltage input (depending on the energy direction). To increase the capacity of this basic configuration, auxiliary units or semiconductors are switched in parallel.

In the semiconductor unit known from Debruyne up to 6 semiconductor modules are configured on a heat sink. In the semiconductor unit described by Lüttin, 2 or 4 semiconductor modules IPM (IPM = integrated power module) are combined to form one phase module. The IPM has an insulated cooler incorporated and is connected to the static converter cooling circuit via 2 cooling connectors. Depending on the power required, in the case of the Debruyne unit up to 3, and in the case of the Lüttin unit up to 2, auxiliary units can be switched in parallel. Parallel connection of these units is implemented on the output side of this semiconductor module unit. The necessary sensors such as current transformers are positioned separately from this unit within the converter cabinet.

This configuration principle has a number of disadvantages. The units described above have an open design and are consequently subject to the same degree of contamination as the other contents of the converter cabinet. Where there are defects, the destruction of the semiconductors by arcing and the unprotected design leads to contamination of adjacent converter units. The open construction method also causes greater contamination inside the semiconductor area, requiring greater current leakage- and air-gaps, which in turn has a negative effect on the low inductive connection structure and consequently on voltage and switching losses.

Since the configuration connections of the circuit are on the output side of the unit, the necessary output current transformers are arranged on the side of the converter cabinet. This configuration principle results in additional connections and interfaces. Furthermore, the converter unit, taken on its own, cannot be functionally tested separately from the rest of the configuration.

Of particular importance is the fact that there are substantial asymmetries with regard to the DC-busbar and AC-alternating voltage outputs. These asymmetries reduce capacity and reliability particularly in cases of high power or high load where the semiconductor elements are working close to their maximum capacities.

In recent years, particularly in the field of rail traction, it has become convenient to use such IGBT converters to replace GTO (Gate Turnoff) Thyristor based devices. In order to achieve the same capacity of such existing GTO devices it is frequently necessary to combine a number of individual IGBTs in parallel. Industry has adapted to these demands by providing IGBT modules which may combine a number of individual IGBT units in parallel. Further parallel connection of such IGBT modules further increases capacity but also increases the total number of units which are connected in parallel. Any difference in loading of the individual units will tend to lead to failure of the weakest link.

There is therefore a need for a semiconductor based converter module which can easily provide adjustment of capacity by parallel switching of semiconductor modules using configurable symmetrical and low-inductive busbars. Such a device should preferably be protected from dirt, thereby providing a low-inductive busbar structure with reduced current leakage and air gaps. It is additionally desirable that the semiconductor gate drives be protected from the power section to prevent electromagnetic interference with the control. Furthermore, it is also desirable to provide a cost effective and low-maintenance converter module which is effectively self contained, has limited interfaces to the rest of the converter cabinet and which functions as an operational unit that can be functionally tested using integrated current and voltage sensors and optionally an integrated control board.

According to the present invention there is provided a converter module comprising a heat sink and a semiconductor phase mounted on the heat sink, the semiconductor phase comprising a pair of semiconductor modules having an AC busbar connected to the emitter of one semiconductor module and the collector of the other semiconductor module and a pair of DC busbars connected respectively to the remaining collector and emitter terminals of the pair of semiconductor modules, the AC busbar being connected to form a substantially symmetrical low inductance system.

Advantageously, in order to provide increased performance, the semiconductor phase can comprises a plurality of pairs of semiconductor modules arranged in parallel and the AC busbar is arranged substantially symmetrically between the parallel pairs of semiconductor modules.

It is further advantageous that the converter be shielded from ambient contamination, to this end the converter is provided with an enclosed housing, the semiconductor modules and busbars being located within the housing.

It is particularly beneficial if the gate drive required to control operation of the individual semiconductor units is shielded from the electromagnetic field of the semiconductor modules.

To this end, the gate drive may be provided on the opposite side of the heat sink from the semiconductor modules.

Further advantages of the present invention are achieved according to the features of the dependent claims.

Embodiments of the present invention will now be described, by way of example only, having reference to the accompanying figures, in which:
Fig. 1 shows an IGBT-semiconductor module with connections according to the present invention;
Fig. 2a shows a heat sink with a configuration of 12 semiconductor modules according to the present invention;
Fig. 2b shows a heat sink with an alternative configuration of 12 semiconductor modules according to the present invention;
Fig. 3a shows an asymmetrical AC-connection with 2 IGBT-modules in parallel;
Fig. 3b shows an alternative circuit diagram of the asymmetrical configuration in accordance with Fig. 3a;
Fig. 4a shows a symmetrical AC-connection with in each case 2 IGBT modules in parallel;
Fig. 4b shows a circuit diagram of an alternative arrangement of the symmetrical AC-connection in accordance with Fig.4a with in each case 2 IGBT modules in parallel;
Fig.5a, 5b show further variations of a symmetrical AC-connection with in each case 2 IGBT modules in parallel;
Fig. 5c shows an alternative circuit diagram of the symmetrical configuration in accordance with Fig. 5a and Fig. 5b;
Fig.6a, 6b, 6c show cross-sectional configurations for symmetrical AC-connection;
Fig.7a, 7b,7c,7d show examples of configurations of the converter module;
Fig.7e, 7f show examples of the heat sink rear surface with gate drives, control board and cooling circuit connection;
Fig.8a, 8b, 8c, 8d show a 6―phase configuration (two 3-phase inverters) with one IGBT pair per function and AC-connections;
Fig.9a, 9b, 9c, 9d show a 3-phase inverter with in each case 2 parallel IGBT pairs and AC connections;
Fig.10a,10b, 10c shows two single phases with in each case 3 parallel IGBT pairs and AC-connections;
Fig. 11 a, 11b, 11c show a single phase with 6 parallel IGBT pairs and AC-connections;
Fig. 12a, 12b show two single phases in 3-point circuit with in each case one IGBT pair per function and AC-connections; and
Fig. 13a, 13b show single phases in 3-point circuit with two parallel IGBT pairs and AC-connections.

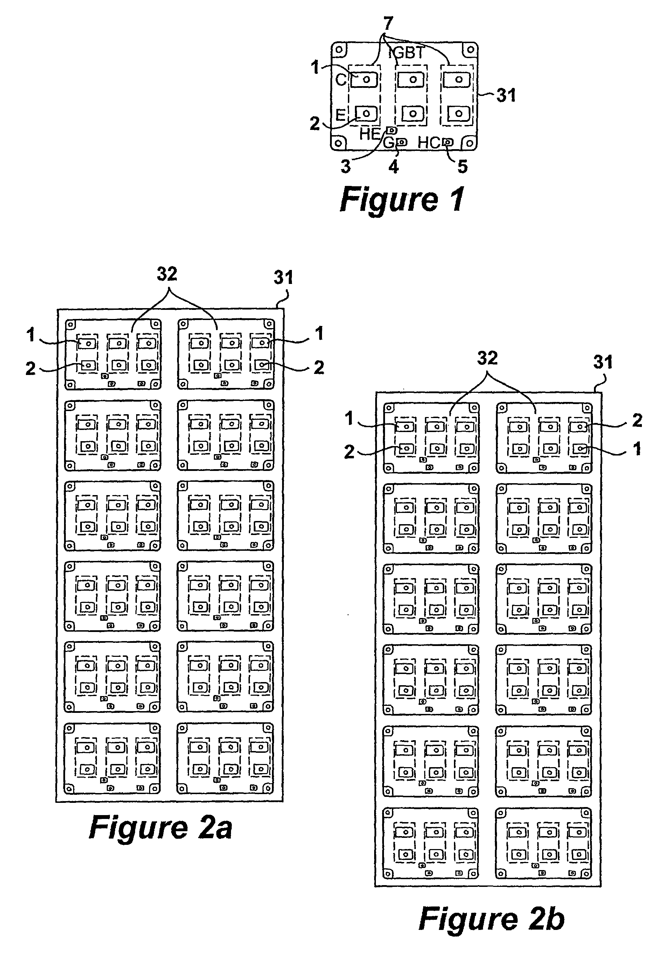

In new high-powered self-driving inverters, IGBT-modules 31 (IGBT = insulated gate bipolar transistor) are used, as shown in Figure 1. The largest design of these modules at present has a surface area of 190mm*140mm. Inside such modules, individual IGBT units are combined in three groups and led outside to 3 separate collector 1 and emitter 2 connections as shown in Fig.1. Each of these IGBT units 7 may itself be formed of a number of individual semiconductor chips internally connected together. The IGBT module shown in Figure 1 is also provided with an auxiliary emitter 3 an auxiliary collector 5 and a gate 4, which may be connected to a gate driver to drive the device according to standard practice. Although reference in the following is made to a gate and a gate driver, this is understood to refer to any appropriate switching device for causing operation of the semiconductor module.

Although IGBT modules comprising three IGBT units are presently known, it is also possible to provide alternative internal configurations with from one to three IGBT units or greater than three such units, able to increase or improve the capacity. It is noted that the symmetrical arrangement according to the present invention facilitates the use of IGBT modules combining increased numbers of IGBT units. The same principle of symmetry may apply equally to other gate units. For the remaining description reference will be made to an IGBT module 31 of the type disclosed in Figure 1. However, it is to be understood that the present invention is applicable to other modules.

An increase in capacity is achieved by parallel switching of IGBT modules 31. The power allocation to the parallel IGBT modules 31 is determined by the following factors which partly also influence the internal power allocation of the 3 IGBT units 7 within a module:
o the transmission characteristics of the IGBTs themselves;
o the design of the parallel triggering;
o the temperature level of the parallel semiconductors;
o the busbar to the intermediate circuit capacitance and to the AC-output relating to symmetry properties.

Where there is an increase in capacity in two or more point circuits by means of parallel switching of IGBT-semiconductor modules, the symmetry of the low-inductive busbar structure of the IGBT modules within a phase is of prime importance. There is a distinction to be made here firstly between asymmetries from the IGBT modules to the positive/negative, intermediate circuit connection (DC-busbar), and secondly asymmetries related to the AC-alternating voltage outputs of the parallel units. Both asymmetries result in asymmetrical power allocation and reduce capacity and reliability of the converter module.

An arrangement according to the present invention is shown in Figure 2a and 2b, in which twelve IGBT modules 32 are configured in pairs on a heat sink 31. The collector 1 and emitter 2 connections of the IGBT modules 32 adjacent to each other are in a line in Fig. 2a. In the arrangement of Fig. 2b these connections are staggered. This configuration of IGBT modules according to one aspect of the present invention results in a flexible and freely configurable converter unit with the beneficial features described below.

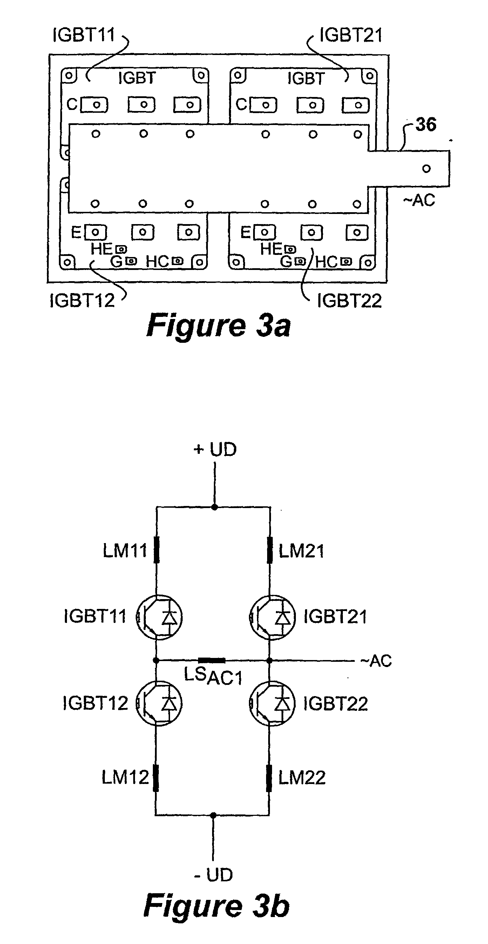

Fig. 3a shows an example of a busbar of the AC voltage output of an IGBT phase with two parallel IGBT module pairs. The design of the AC busbar 36 is such that it spans the adjacent collectors and emiters of IGBTs 11, 21, 12 and 22. As can be seen from Fig. 3a, this serves to provide a symmetrical connection between the respective pairs of individual IGBT units 7 within each IGBT module. According to the present invention, this substantially ensures that the individual IGBT units 7 are all subjected to the same load. Nevertheless, the arrangement of Fig 3a still includes a limited asymmetry in the external connection of the AC busbar 36.

As shown in the alternative diagram corresponding to Fig. 3b, this AC busbar 36 can lead, through the steepness of the load current curve to a drop in voltage LS_{AC1}*di/dt at leakage inductance LS_{AC1}. Depending on the load steepness and form of configuration the voltage at inductance LS_{AC1} can reach values of from 0.2V up to a few volts. This voltage attempts to drive a corresponding ring current and results in asymmetries in power between the parallel operating IGBTs 11 and 21 or between the IGBTs 12 and 22.

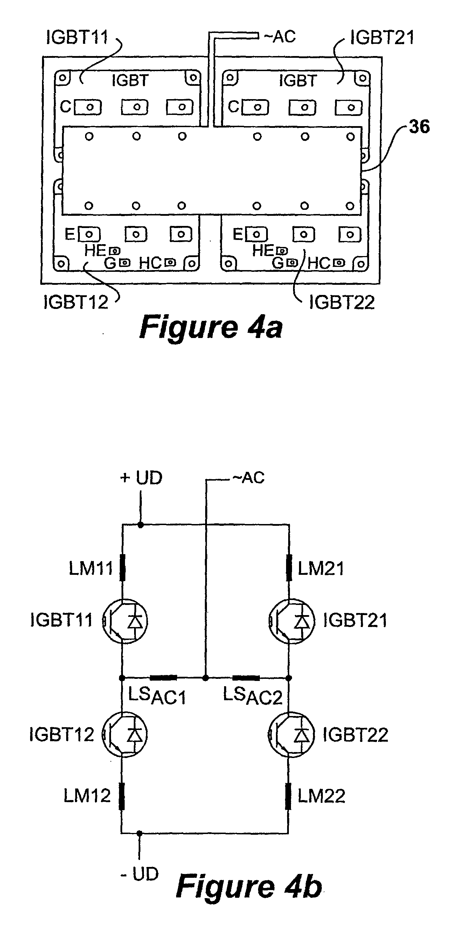

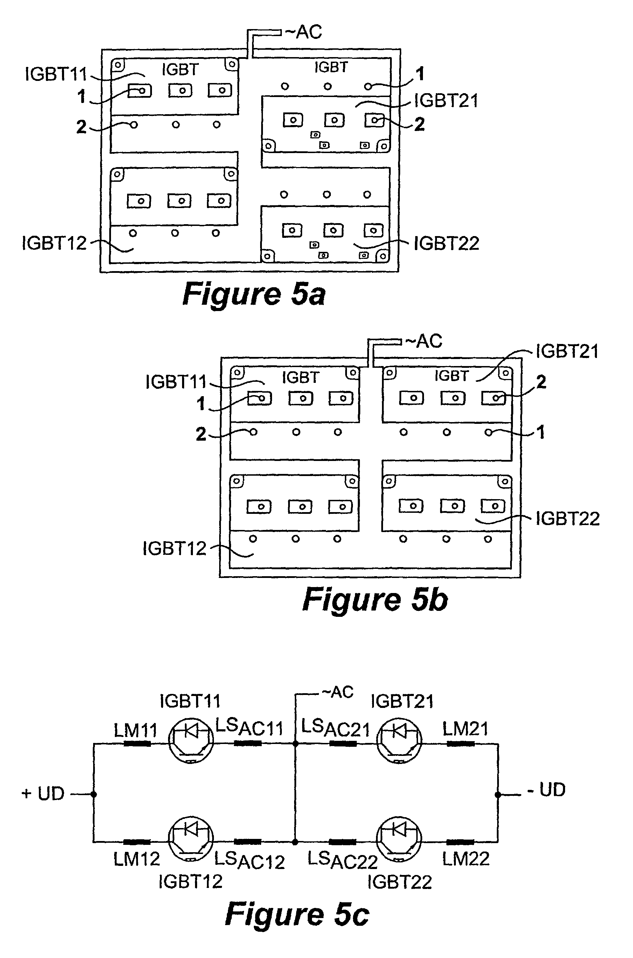

This disadvantage is avoided according to the present invention if the AC-junction point of the parallel IGBT pairs, as shown in the parallel circuit of Fig. 4a, 5a and 5b, is configured centrally between the parallel IGBTs (see alternate diagrams Fig. 4b and 5c). In the configuration in Fig. 5b the collector and emitter connections of the adjacent IGBTs are staggered as shown in Fig. 2b, resulting in possible constructional benefits for the AC-busbar of the IGBTs.

A preferred symmetry is shown in the busbar 36 according to Fig. 4a, since this guarantees both symmetry of the parallel IGBT pairs and at the same time ensures symmetry between commutations of the upper and lower IGBTs of a phase (as mentioned in relation to Fig. 3a above). This ensures that there is also symmetrical power allocation inside the parallel IGBT-units 7 in an IGBT module 32.

These symmetries are particularly important where the IGBTs are in frequent use, for dynamic processes and future semiconductor developments with lower transmission losses. In such cases, the influence of the asymmetrical part of the busbar on the power allocation of the parallel semiconductors increases proportionately.

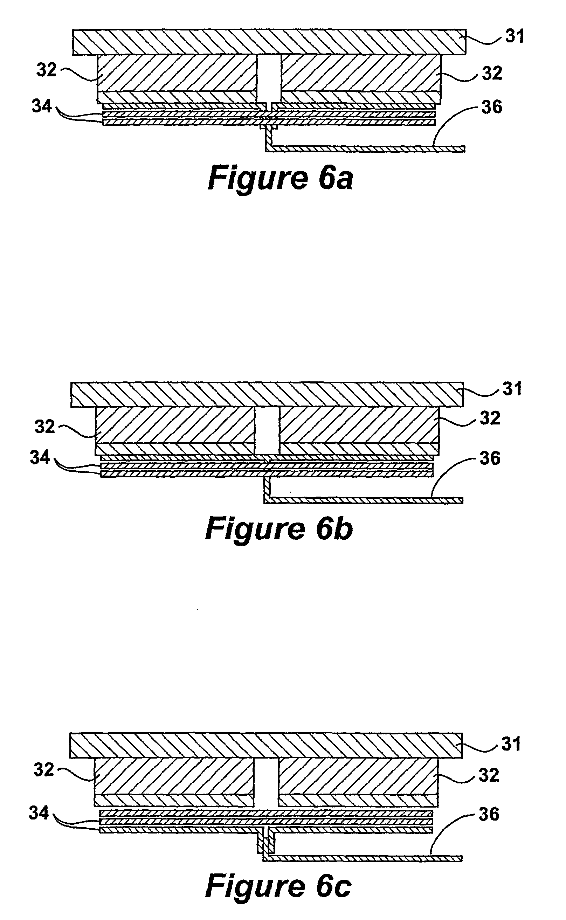

Structural examples for a solution with such features are shown in Fig. 6a, 6b and 6c. The AC-junction point is here symmetrically configured mid-way between the IGBT modules 32. In Fig. 6a and 6b the connected AC busbar 36 orthogonally cuts the low inductance DC-intermediate circuit busbar 34 that is configured over the IGBT modules 32. In Fig. 6a the flat AC-busbar 36 is attached for every IGBT to the centre (junction point of the AC-output busbar) via individual busbars corresponding to Fig. 5a. In Fig 6b a flat AC- layer connects two IGBTs. In parallel circuits correspondingly more IGBTs are connected. At the centre, the AC-output busbar is then connected with this AC-layer, which in turn cuts the DC-busbar 34 layer orthogonally. Alternatively this AC-output busbar can also be directed outwards between IGBT and the DC-busbar level.

In Fig. 6c the AC-potential points are taken individually through the lower-inductive intermediate circuit power busbar layer. A flat AC-busbar layer connects the AC-potentials of a phase. The AC-output busbar 36 is in turn connected centrally.

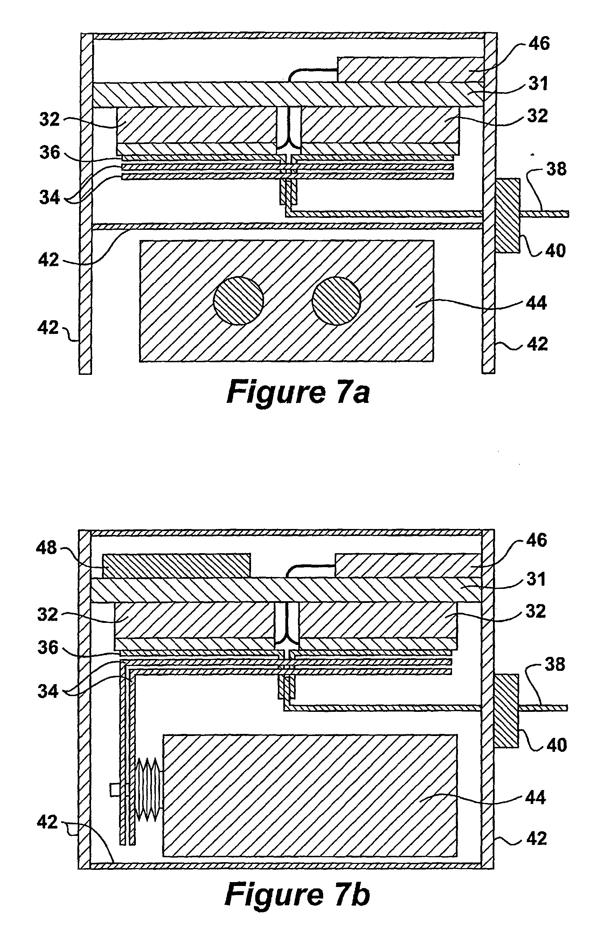

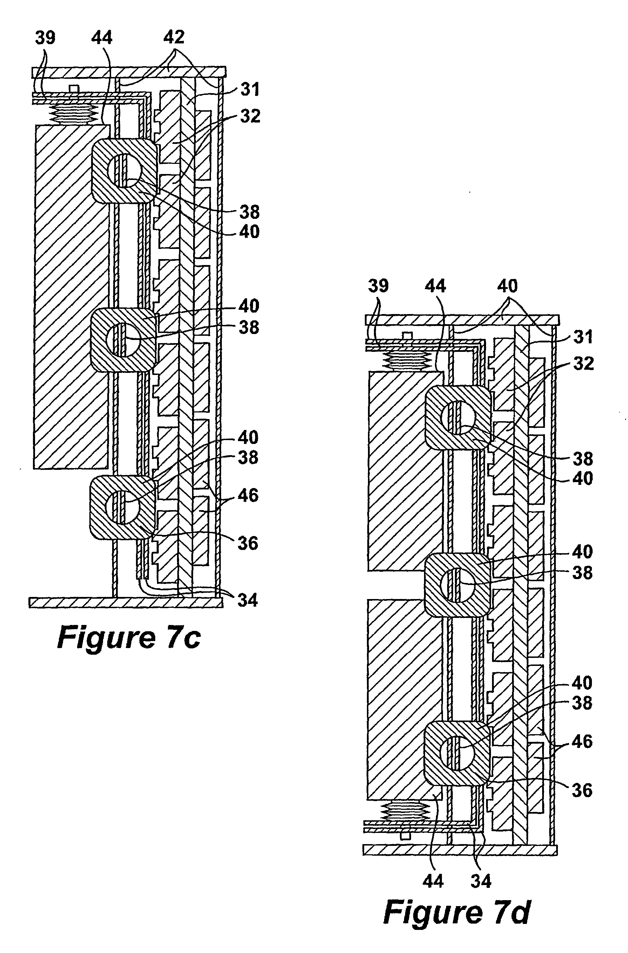

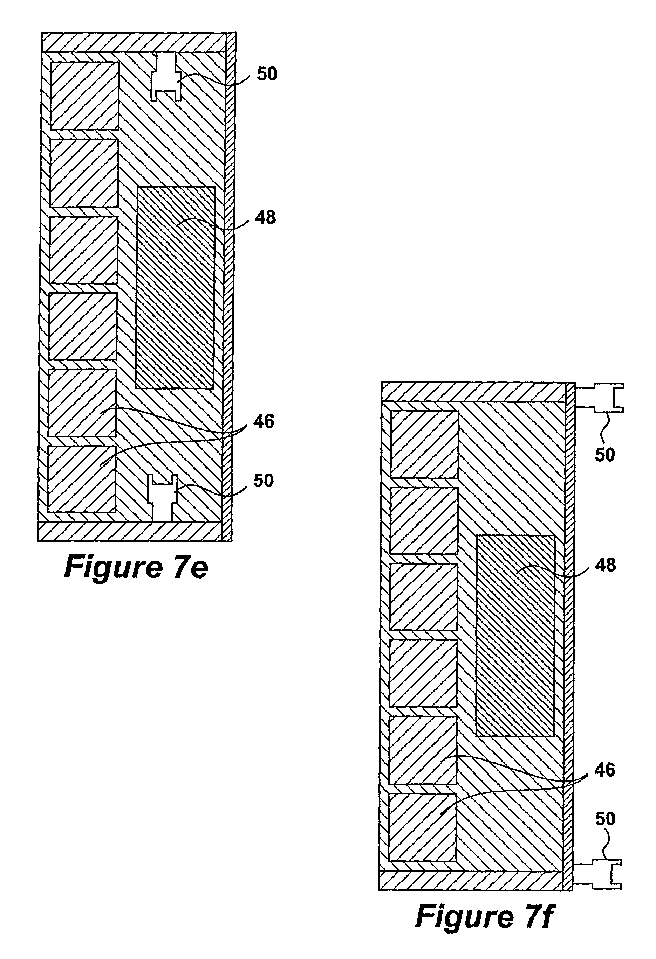

Additional beneficial properties of the static converter unit of the present invention are shown according to the basic configurations in figures 7a to 7f and are characterised as follows:

As shown in Fig. 7a the IGBT modules 32 with the power busbar layers 34, 36, the IGBT gate drives 46, and, if desired, an integrated control board (see Fig 7b) are configured in a closed housing 42 to protect them from dirt. The housing walls of the unit are used simultaneously as base plates for sensors such as power and voltage converters;

The AC busbar 36 is taken out as shown in the design example of Fig. 7a directly through the wall of the housing 42 as an AC terminal 38;

The AC terminal passes through a current sensor 40 mounted on the wall of the housing 42;

The power electronics interfaces of the static converter unit consist only of the corresponding AC- terminals 38 and the positive and negative DC terminals (not shown) to the intermediate circuit, (in 3-level inverters a further centre connection may also be present);

The gate drives 46 are configured in accordance with Fig. 7a, 7e on the rear face of the heat sink that is protected from the power semiconductors and are readily accessible. The necessary semiconductor connections to the control board are taken through corresponding cut-outs (holes) in the heat sink;

The control board 48 for this unit which may be incorporated into the unit is also in the protected EM shielded area at the rear of the heat sink as shown in Fig 7e, which also indicates the cooling fluid connections 50 for the heat sink.

The intermediate circuit capacitance / partial capacitance of the intermediate circuit may be configured directly at the DC-intermediate circuit power busbar layer 34 as shown in the example in Fig. 7c or with symmetrical capacity configuration in accordance with Fig. 7b, or symmetrically at the terminals of the DC-power busbar layer corresponding to Fig. 7c.

Examples of circuits according to the present invention will now be described.

For the sake of clarity, in the following examples only the AC-IGBT connections are shown by connecting lines in the figures. The allocation of the positive or negative potentials not shown to the collector or emitter connections that are still free is determined by the pre-set AC-busbar. In order to attain low inductive configurations the AC-busbar is configured as a flat busbar as shown in Figures 3a, 4a, 5a or 5b, as is the DC-intermediate circuit connection.

The following basic circuits can be configured simply corresponding to the main AC-connection shown on the basis of the variations described above:

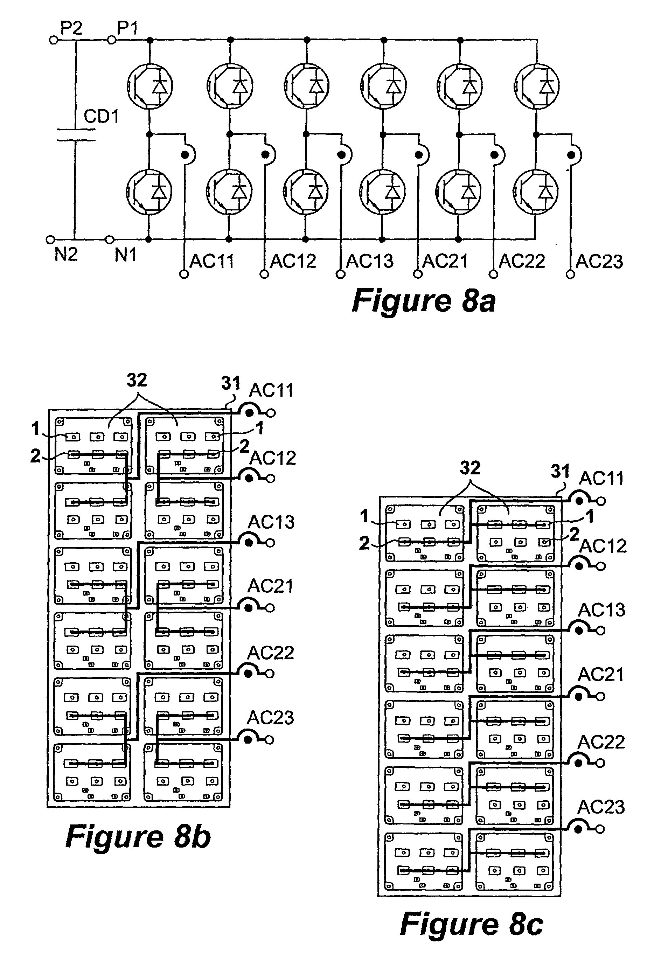

6 independent single phases (two 3-phase inverters) each one having one IGBT pair per function (Fig. 8a) and connection in accordance with Fig. 8b corresponding to the features in Fig. 4a;

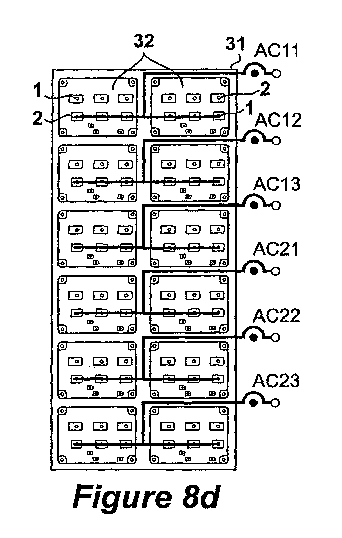

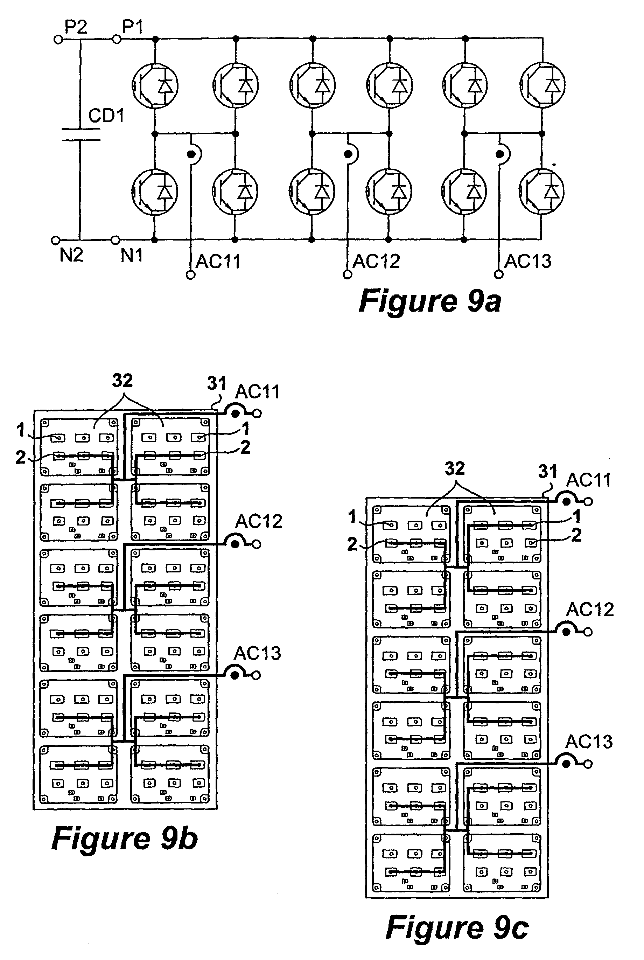

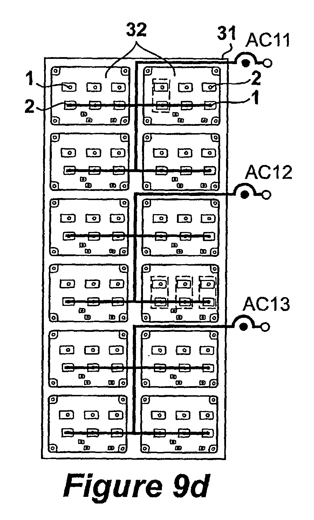

Alternatively the connection as shown in Fig 8c or Fig 8d with the features of Fig. 5a or 5b. One 3-phase inverter each having 2 parallel IGBT pairs (Fig. 9a) and connection as shown in the examples in Fig. 9b, 9c or 9d with the features of Fig. 4a, 5a or 5b;

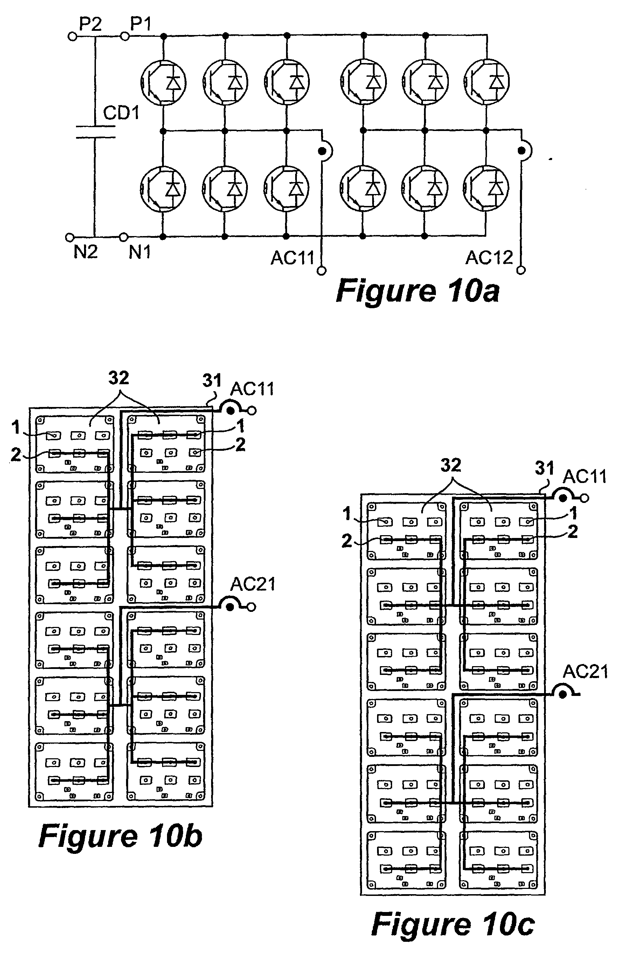

Two single phases each having 3 IGBT pairs in parallel (Fig. 10a), connection in accordance with Fig 10b,10c with the corresponding features of Fig. 5a or 5b;

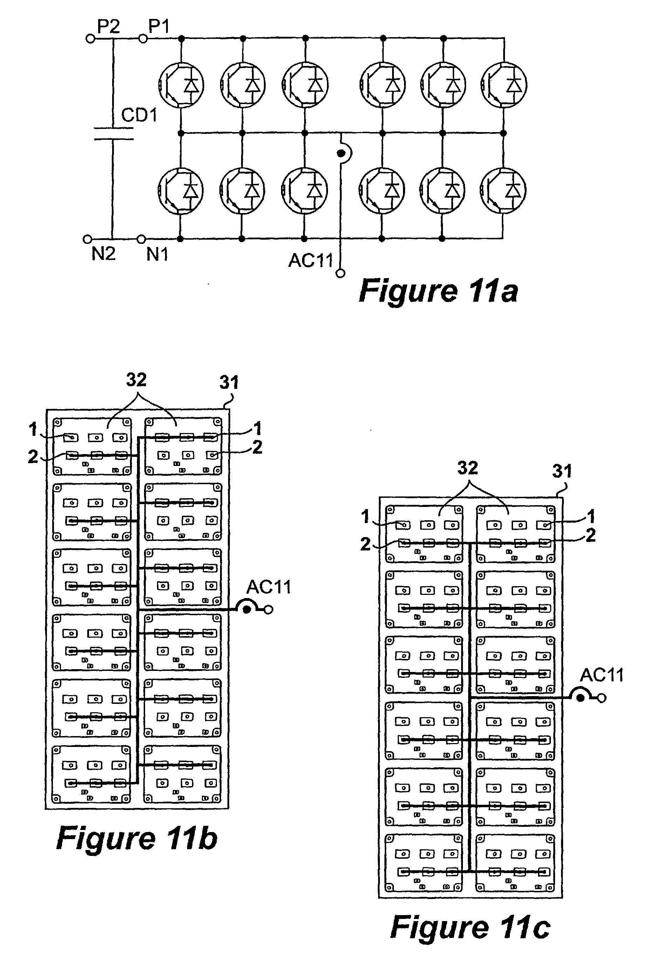

One single phase with 4 to 6 parallel IGBT pairs (Fig. 11a), connection in accordance with Fig 11b, 11c with the corresponding features in accordance with Fig. 5a or 5b;

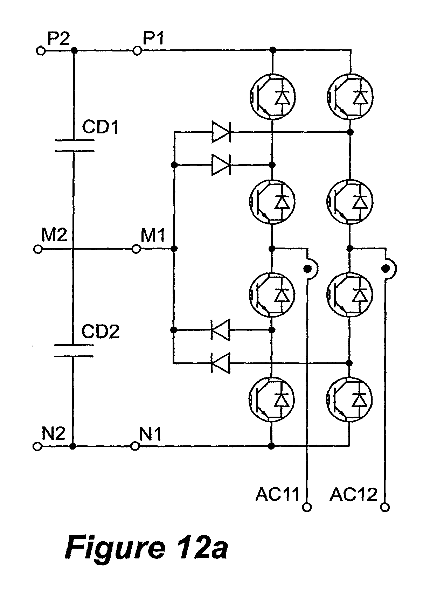

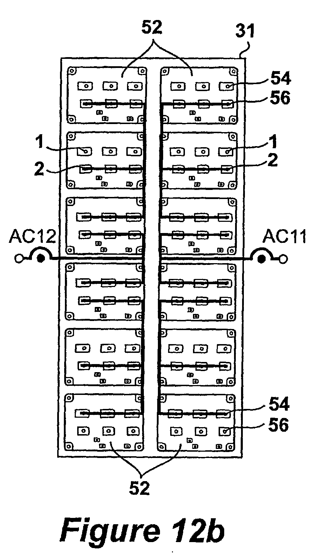

Two single phases in 3 point circuit each having one IGBT pair per function (Fig. 12a) and connection in accordance with Fig.12b; and

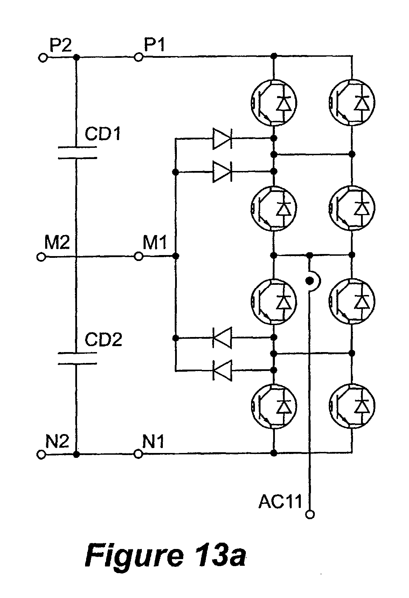

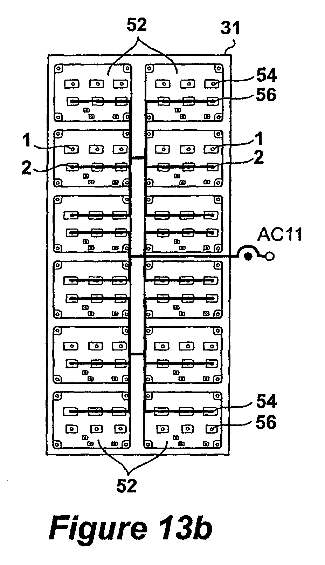

One single phase in 3-point circuit each with two parallel IGBT pairs (Fig. 13a) and connection in accordance with Fig.13b.

Further embodiments and modifications to the specific embodiments described above will be readily apparent to the person skilled in the art and may be provided without departing from the scope and spirit of the present invention.

## Claims

1. A converter module comprising a heat sink and an semiconductor phase mounted on the heat sink, the semiconductor phase comprising a pair of semiconductor modules having an AC busbar connected to the emitter of one semiconductor module and the collector of the other semiconductor module and a pair of DC busbars connected respectively to the remaining collector and emitter terminals of the pair of semiconductor modules, the AC busbar being connected to form a substantially symmetrical low inductance system.

2. A converter module according to claim 1, wherein the semiconductor phase comprises a plurality of pairs of semiconductor modules arranged in parallel and the AC busbar is arranged substantially symmetrically between the parallel pairs of semiconductor modules.

3. A converter module according to claim 1 or claim 2, wherein each semiconductor module comprises a plurality of semiconductor units each having an emitter and collector terminal and the AC busbar connects the respective plurality of emitter and collector terminals in parallel and ensures substantial symmetry between the semiconductor units.

4. A converter module according to any preceding claim wherein the busbars are formed as generally flat strips.

5. A converter module according to claim 4 wherein the pair of semiconductor modules are arranged on the heat sink adjacent to one another with the emitter of the one semiconductor module adjacent to the collector of the other semiconductor module and wherein the AC busbar is of sufficient width to span the adjacent emitters and collectors of the adjacent semiconductor modules.

6. A converter module according to any preceding claim wherein the DC busbars are arranged substantially symmetrically between the respective semiconductor modules and/or units.

7. A converter module according to any preceding claim wherein a plurality of semiconductor phases are mounted on the heat sink and connected between the DC busbars, each semiconductor phase being provided with an AC busbar.

8. A converter module according to claim 7 and claim 2 comprising three semiconductor phases, each semiconductor phase comprising two pairs of semiconductor modules arranged in parallel.

9. A converter module according to any preceding claim further comprising an enclosed housing, the semiconductor modules and busbars being located within the housing.

10. A converter module according to any preceding claim further comprising a capacitance arranged across the DC busbars and located within the housing.

11. A converter module according to claim 10 wherein the capacitance comprises a pair of symmetrically mounted capacitors.

12. A converter module according to any of claims 9 to 11 wherein all configuration connections between semiconductor modules are executed by the busbars within the housing.

13. A converter module according to claim 12 wherein an AC terminal is provided on the housing connected to the AC busbar and a current sensor is arranged on the housing around the AC terminal.

14. A converter module according to any preceding claim, further comprising a gate drive provided on the opposite side of the heat sink from the semiconductor modules.

15. A converter module according to claim 14, wherein the gate drive is connected symmetrically to a pair of semiconductor modules.

16. A converter module according to claim 15, wherein the connection from the gate drive to the gates of the pair of semiconductor modules passes through the cooling plate substantially equidistant between the pair of semiconductor modules.

17. A converter module according to any preceding claim, further comprising a control board provided on the opposite side of the heat sink from the semiconductor modules.

18. A converter module according to any preceding claim, wherein the semiconductor units are insulated gate bipolar transistors.
